# EUROPEAN PATENT APPLICATION

(11) **EP 2 256 826 A2**
(43) Date of publication of application: **01.12.2010**
(21) Application number: 10163989.6
(22) Date of filing: 27.05.2010
(51) Int. Cl.: H01L 31/048

(54) **Adhesive seal material for end portion of frameless solar cell module, frameless solar cell module, and sealed structure of end portion thereof**

(30) Priority: 29.05.2009 JP 2009131250
(71) Applicant: Nitto Denko Corporation, Ibaraki-shi Osaka 567-8680 (JP)
(72) Inventor: Fujii, Hiroki, Osaka 567-8680 (JP)
(74) Representative: Schwabe - Sandmair - Marx

(57) **Abstract**

An adhesive seal material for an end portion of a frameless solar cell module is an adhesive sealing member for an end portion of a frameless solar cell module which is bonded to an end portion of a frameless solar cell module, and includes a base material and an adhesive layer formed on a surface of the base material. The base material includes a reinforcement layer having a top surface on which the adhesive layer is laminated, and a barrier layer formed on a back surface of the reinforcement layer.

## Description

### BACKGROUND OF THE INVENTION

### Field of the Invention

The present invention relates to a adhesive seal material for an end portion of a frameless solar cell module, a frameless solar cell module, and a sealed structure of an end portion thereof, and particularly to an adhesive seal material for an end portion of a frameless solar cell module which is bonded to an end portion of a frameless solar cell module, a frameless solar cell module having the adhesive seal material bonded thereto, and a sealed structure of an end portion thereof.

### Description of the Related Art

In recent years, a frameless solar cell module has been proposed in which a metallic frame (framework) having rigidity is not provided at a peripheral end portion thereof for the purpose of reducing weight and cost.

In addition, it has been proposed to seal the laminate surface of a side end of a frameless solar cell module with a metallic sealing member (see, e.g., Japanese Unexamined Patent No. 2008-283035).

It has also been proposed to cover an end portion of the main body of a frameless solar cell module with an end-surface sealing member including an outer-layer member made of a heat resistant rubber-based material, and an inner-layer member formed on a surface thereof and made of ethylene-vinyl acetate (EVA which is a thermosetting resin) (see, e.g., Japanese Unexamined Patent No. 2005-347395).

In Japanese Unexamined Patent No. 2008-283035, the sealing member is brought to abut against the laminate surface of the side end of the frameless solar cell module to prevent the entrance of humidity (moisture) into the laminate surface.

In Japanese Unexamined Patent No. 2005-347395, the end-surface sealing member is disposed so as to bring the inner-layer member into contact with the end portion of the main body of the frameless solar cell module, and then cured by heating to ensure adhesion between the inner-layer member and the main body of the frameless solar cell module.

### SUMMARY OF THE INVENTION

However, in Japanese Unexamined Patent No. 2008-283035, it is difficult to process the metallic sealing member in accordance with the shape of the peripheral side end of the frameless solar cell module.

On the other hand, in Japanese Unexamined Patent No. 2005-347395, the inner-layer member of the end-surface sealing member is made of EVA, so that moisture tends to easily enter the gap between the inner-layer member and the end portion of the main body of the frameless solar cell module. In that case, a problem arises that a solar cell is short-circuited.

An object of the present invention to provide an adhesive seal material for an end portion of a frameless solar cell module that can be easily bonded to an end portion of a frameless solar cell module, has excellent adhesion to the frameless solar cell module, also has an excellent water vapor barrier property as well as excellent light resistance, weathering resistance, and heat resistance, and further exhibits an excellent cushioning property to its surroundings, a frameless solar cell module using the adhesive seal material, and a sealed structure of an end portion thereof.

An adhesive seal material for an end portion a frameless solar cell module of the present invention is an adhesive seal material for an end portion a frameless solar cell module which is bonded to an end portion of a frameless solar cell module, including a base material, and an adhesive layer formed on a surface of the base material, wherein the base material includes a reinforcement layer having a top surface on which the adhesive layer is laminated, and a barrier layer formed on a back surface of the reinforcement layer.

In the adhesive seal material for the end portion of the frameless solar cell module of the present invention, it is preferable that the barrier layer is a metal foil, and the metal foil is an aluminum foil and/or a copper foil.

In the adhesive seal material for the end portion of the frameless solar cell module of the present invention, it is preferable that the reinforcement layer is a split-fiber non-woven fabric.

In the adhesive seal material for the end portion of the frameless solar cell module of the present invention, it is preferable that the adhesive layer is made of a butyl-based adhesive composition.

In the adhesive seal material for the end portion of the frameless solar cell module of the present invention, it is preferable that a moisture permeability at a temperature of 40 °C and a relative humidity of 90% in accordance with a moisture permeability test method of JIS Z0208 is not more than 0.2 g/m²/24 hours.

It is preferable that the adhesive seal material for the end portion of the frameless solar cell module of the present invention further includes a protective layer formed on the back surface of the barrier layer to protect the adhesive seal material for the end portion of the frameless solar cell module.

In a frameless solar cell module of the present invention, the adhesive layer of the foregoing adhesive seal material for the end portion of the frameless solar cell module is bonded to an end portion thereof

It is preferable that the frameless solar cell module of the present invention includes a solar cell element, a sealing resin layer sealing the solar cell element, and a cover glass layer covering the sealing resin layer, wherein the adhesive seal material for the end portion of the frameless solar cell module is bonded continuously to at least a side surface of the sealing resin and a side surface of the cover glass layer.

In a sealed structure of an end portion of a frameless solar cell module of the present invention, the foregoing adhesive seal material for the end portion of the frameless solar cell module is bonded to the end portion of the frameless solar cell module.

The adhesive seal material for the end portion of the frameless solar cell module of the present invention can be easily bonded to the frameless solar cell module.

In addition, since the adhesive seal material for the end portion of the frameless solar cell module of the present invention has excellent adhesion to the frameless solar cell module, strongadhesion to the frameless solar cell module can be achieved.

Also, the adhesive seal material for the end portion of the frameless solar cell module of the present invention has the excellent water vapor barrier property. Therefore, by imparting the excellent water vapor barrier property to the end portion of the frameless solar cell module, it is possible to prevent the entrance of moisture into the gap between the adhesive seal material for the end portion of the frameless solar cell module and the end portion of the frameless solar cell module, and prevent the short circuit of a solar cell element. This allows improvements in the water resistance and reliability of the frameless solar cell module of the present invention.

Also, the adhesive seal material for the end portion of the frameless solar cell module of the present invention has the excellent light resistance, weathering resistance, and heat resistance. Therefore, even when the frameless solar cell module of the present invention is used in a severe environment, it is possible to ensure water resistance, and ensure reliability over a long period of time.

Moreover, the adhesive seal material for the end portion of the frameless solar cell module of the present invention exhibits an excellent cushioning property to its surroundings. Therefore, during transportation or the like, the end portion of the frameless solar cell module can be effectively prevented from coming into contact with its surroundings, and being damaged thereby.
This allows protection of the end portion of the frameless solar cell module of the present invention.

The frameless solar cell module and the sealed structure of the end portion thereof of the present invention can ensure excellent water resistance and reliability as well as excellent endurance.

### BRIEF DESCRIPTION OF THE DRAWINGS

FIG. 1 is a cross-sectional view of an embodiment (implementation in which a base material is formed of a reinforcement layer and a barrier layer) of an adhesive seal material for an end portion of a frameless solar cell module of the present invention;
FIG. 2 is a cross-sectional view of an embodiment of a frameless solar cell module of the present invention to which the adhesive seal material for the end portion of the frameless solar cell module of FIG. 1 is bonded;
FIG. 3 is a cross-sectional view of another embodiment (implementation in which a protective layer is formed on the back surface of a barrier layer) of the adhesive seal material for the end portion of the frameless solar cell module of the present invention;
FIG. 4 is a cross-sectional view of an adhesive seal material for an end portion of a frameless solar cell module of Comparative Example 1;
FIG. 5 is a cross-sectional view of an adhesive seal material for an end portion of a frameless solar cell module of Comparative Example 2; and
FIG. 6 is a cross-sectional view of an adhesive seal material for an end portion of a frameless solar cell module of Comparative Example 3.

### DETAILED DESCRIPTION OF THE INVENTION

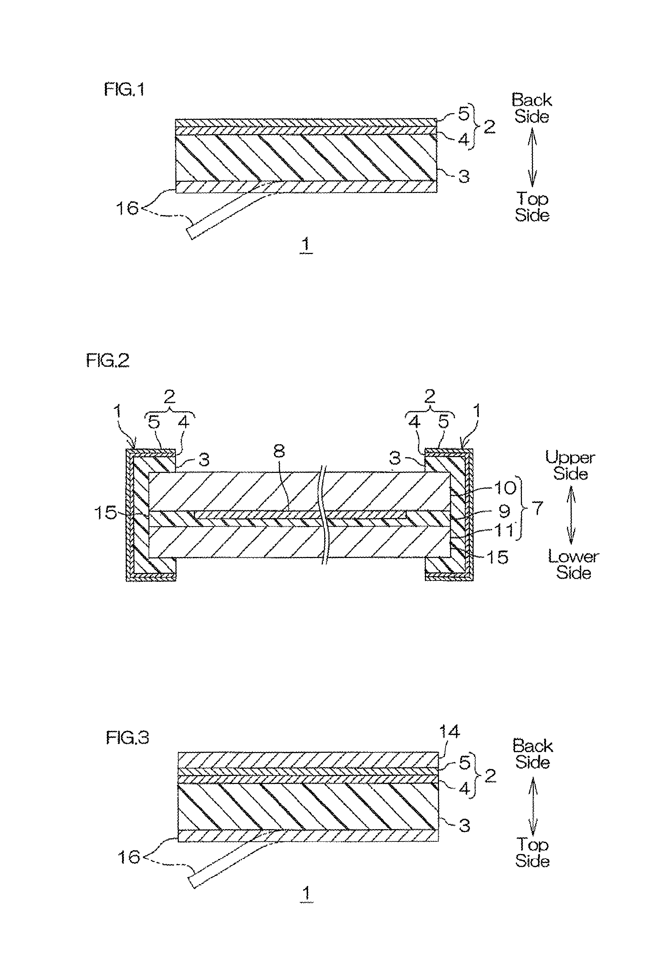

FIG. 1 is a cross-sectional view of an embodiment (implementation in which a base material is formed of a reinforcement layer and a barrier layer) of an adhesive seal material for an end portion of a frameless solar cell module of the present invention. FIG. 2 is a cross-sectional view of an embodiment of a frameless solar cell module of the present invention to which the adhesive seal material for the end portion of the frameless solar cell module of FIG. 1 is bonded.

In FIGS. 1 and 2, an adhesive seal material 1 for an end portion of a frameless solar cell module is bonded to a peripheral end portion 15 of a frameless solar cell module 7. Specifically, the adhesive seal material 1 is bonded to seal the peripheral end portion 15 of the frameless solar cell module 7.

The adhesive seal material 1 for the end portion of the frameless solar cell module includes a base material 2, and an adhesive layer 3 formed on a surface of the base material 2, as shown in FIG 1.

The base material 2 includes a reinforcement layer 4 having a top surface on which the adhesive layer 3 is laminated, and a barrier layer 5 formed on a back surface of the reinforcement layer 4.

The reinforcement layer 4 is provided so as to impart tenacity to the barrier layer 5, and formed in a sheet shape to have a light weight. Specifically, a split-fiber non-woven fabric or the like is used for the reinforcement layer 4.

The split-fiber non-woven fabric is a net-like material in which, e.g., net-like (mesh) sheets are laminated such that the respective directions of orientation thereof perpendicularly cross each other, e.g., a net-like material in which a plurality of yarns each oriented in one direction are combined such that the respective directions of orientation thereof perpendicularly cross each other.

Examples of a material used to form the split-fiber non-woven fabric include a polyolefin resin such as polyethylene or polypropylene and, preferably, polyethylene is used.

As the split-fiber non-woven fabric, a commercially available one can be usually used and, specifically, CLAF (produced by NISSEKI PLASTO CO., LTD.) or the like is used.

The split-fiber non-woven fabric has a basis weight in a range of, e.g., 18 to 48 g/m², and the maximum length of an opening (maximum interfiber spacing) therein is in a range of, e.g., 1.4 to 2.8 mm.

The thickness of the reinforcement layer 4 is in a range of, e.g., 50 to 300 µm, or preferably 70 to 130 µm.

The barrier layer 5 is provided to impart tenacity to the adhesive seal material 1 for the end portion of the frameless solar cell module, and ensure a water vapor barrier property. The barrier layer 5 is formed in a sheet-like shape, and preferably formed over the entire back surface of the reinforcement layer 4.

Examples of the barrier layer 5 to be used include a metal foil and a resin sheet.

Examples of the metal foil to be used include a metal foil of aluminum, gold, silver, copper, nickel, cobalt, chromium, tin, or the like and a metal oxide foil made of an oxide of any of the metals shown above.

Examples of the resin sheet to be used include an ester sheet such as a polyethylene terephthalate (PET) sheet or a polyethylene naphthalate (PET) sheet, and a vapor-deposited oxide sheet in which an oxide such as silicon dioxide or aluminum oxide is vapor-deposited on a surface of the ester sheet mentioned above.

The barrier layer 5 can be laminated using one type thereof alone or a plurality of types thereof in combination.

As the barrier layer 5, a metal foil is used preferably in terms of the water vapor barrier property or, more preferably, an aluminum foil or a copper foil is used.

The thickness of the barrier layer 5 is in a range of, e.g., 1 to 100 µm, or preferably 5 to 50 µm.

To form the base material 2, it is sufficient to laminate the barrier layer 5 on the back surface of the reinforcement layer 4. In the case where the barrier layer 5 is formed of, e.g., a metal foil, the reinforcement layer 4 is formed first on an exfoliate sheet (not shown), and then the barrier layer 5 is formed by performing, from above the exfoliate sheet including the reinforcement layer 4, a bonding process of the foregoing metal material forming the metal foil using an ionomer or a vapor deposition process (such as, e.g., sputtering) of depositing the foregoing metal material.

The thickness of the base material 2 thus formed is in a range of, e.g., 51 to 400 µm, or preferably 75 to 180 µm.

The adhesive layer 3 is made of, e.g., an adhesive composition, or preferably a butyl-based adhesive composition.

The butyl-based adhesive composition contains, e.g., a butyl rubber as an essential component, and contains a tackifier, a filler, a softener, and a vulcanizer as optional components.

The type of the butyl rubber is not particularly limited. For example, a reclaimed butyl rubber, a synthetic butyl rubber, or the like is used.

The Mooney viscosity of the butyl rubber is in a range of, e.g., 40 to 60 (ML1+4, 100 °C), or 45 to 55 (ML1+4, 100 °C).

As the butyl rubber, one type thereof can be used alone or a plurality of types thereof can be used in combination.

Examples of the tackifier to be used include a petroleum-type resin, a phenol-type resin, a rosin-type resin, and a terpene-type resin.

Examples of the filler to be used include calcium carbonate (e.g., heavy calcium carbonate or light calcium carbonate), talc, and magnesium oxide.

Examples of the softener to be used include polybutene (such as, e.g., liquid polybutene) and process oil.

Examples of the vulcanizer to be used include a dinitrosobenzene- type vulcanizer, a quinoide-type vulcanizer, a thiuram-type vulcanizer, a quinonedioxime-type vulcanizer, and a maleimide-type vulcanizer.

As each of the optional components, one type thereof can be used alone or two or more types thereof can be used in combination.

The mixing ratio of the total amount of the optional components to 100 parts by weight of the butyl rubber is in a range of, e.g., 100 to 1000 parts by weight, or preferably 200 to 500 parts by weight.

The mixing ratio of each of the optional components to 100 parts by weight of the butyl rubber is such that the mixing ratio of the tackifier is in a range of, e.g., 20 to 200 parts by weight, or preferably 30 to 150 parts by weight, the mixing ratio of the filler is in a range of, e.g., 10 to 300 parts by weight, or preferably 50 to 200 parts by weight, the mixing ratio of the softener is in a range of 5 to 50 parts by weight, or preferably 10 to 40 parts by weight, and the mixing ratio of the vulcanizer is in a range of, e.g., not more than 20 parts by weight, or preferably not more than 10 parts by weight.

To the butyl-based adhesive composition, a known additive added to the butyl-.based adhesive composition such as an age resistor, a plasticizer, or a vulcanization accelerator can be added at an appropriate ratio.

To prepare the butyl-based adhesive composition, the individual components shown above are mixed at the foregoing mixing ratios, and kneaded. The individual components are kneaded with, e.g., a mixing roll, a kneader (such as, e.g., a pressure kneader or an open kneader), an extruder, or the like. Preferably, the individual components are kneaded with a kneader.

In the case where the pressure kneader or open kneader is used as the kneader, a heating temperature in the kneading is in a range of, e.g., 100 to 120 °C.

In the preparation of the butyl-based adhesive composition, a simultaneous charging method or a master batch method (divided charging method), e.g., is used and, preferably, the master batch method is used.

In the master batch method, for example, as final batch components, a part of the tackifier, the softener, and the vulcanizer are formulated while as master batch components, the other individual components (the butyl rubber, the filler, and the remainder of the tackifier) are formulated.The master batch components are kneaded first to prepare a master batch, and then the obtained master batch and the final batch components are kneaded to obtain the butyl-based adhesive composition (kneaded product).

Then, from the butyl-based adhesive composition thus obtained, the adhesive layer 3 is formed.

To form the adhesive layer 3 from the butyl-based adhesive composition, the butyl-based adhesive composition described above is molded into a sheet shape by a molding method such as, e.g., mixing roll molding, calendar roll molding, extrusion molding, or press molding.

Thereafter, as necessary, an exfoliate sheet 16 is laminated on each of the top surface and back surface of the obtained adhesive layer 3.

As the exfoliate sheet 16, a plastic sheet subjected to a surface treatment using a release agent such as a silicone type, a long-chain alkyl type, a fluorine type, or molybdenum sulfide is used.

The thickness of the adhesive layer 3 thus formed is in a range of, e.g., 10 to 1000 µm, or preferably 200 to 800 µm.

Then, to obatin the adhesive seal material 1 for the end portion of the frameless solar cell module, the base material 2 and the adhesive layer 3 each described above are prepared first, and then the adhesive layer 3 is laminated on the surface of the base material 2.

Specifically, an exfoliate sheet (not shown) laminated on the back surface of the adhesive layer 3 is stripped from the adhesive layer 3, and then the back surface of the adhesive layer 3 is compression-bonded to the top surface of the reinforcement layer 4 of the base material 2.

The adhesive layer 3 is bonded to the reinforcement layer 4 under a pressure in a range of, e.g., 0.1 to 1.0 MPa, or preferably 0.3 to 0.5 MPa.

Thereafter, as necessary, the adhesive seal material 1 for the end portion of the frameless solar cell module is trimmed (cut) into an elongated flat belt shape in accordance with the peripheral length of the peripheral end surface of the frameless solar cell module 7 described later and the thickness thereof (length in the thickness direction of the frameless solar cell module 7).

The adhesive seal material 1 for the end portion of the frameless solar cell module thus obtained has a 180-degree peel adhesion force to a glass plate which is in a range of, e.g., 10 to 120 N/25 mm, or preferably 50 to 110 N/25 mm at a temperature of -40 °C, in a range of, e.g., 3 to 50 N/25 mm, or preferably 5 to 40 N/25 mm at a temperature of 23 °C, and in a range of, e.g., 0.3 to 5 N/25 mm, or preferably 1 to 4.5 N/25 mm at a temperature of 90 °C.

Note that a method of measuring the 180-degree peel adhesion force is described in detail in the evaluation of EXAMPLES described later.

The adhesive seal material 1 for the end portion of the frameless solar cell module also has a moisture permeability at a temperature of 40 °C and a relative humidity of 90% in accordance with a moisture permeability test method of JIS Z0208 which is, e.g., not more than 0.2 g/m²/24 hours, preferably not more than 0.18 g/m²/24 hours, or more preferably not more than 0.16 g/m²/24 hours, and normally not less than 0.01 g/m²/24 hours.

When the moisture permeability shown above exceeds the range shown above, an excellent water vapor barrier property may not be able to be obtained.

Next, the frameless solar cell module 7 having the foregoing adhesive seal material 1 for the end portion of the frameless solar cell module bonded thereto is described with reference to FIG. 2.

The frameless solar cell module 7 is formed in a sheet (panel) shape, and includes a solar cell element 8, a sealing resin layer 9, an upper cover glass layer 10, and a lower cover glass layer 11 each serving as a cover glass layer.

As the solar cell element 8, a known solar cell element such as, e.g., a crystalline silicon type or an amorphous silicon type is used. The solar cell element 8 is in a generally rectangular flat plate shape, and the thickness thereof is in a range of, e.g., 0.15 to 0.20 mm.

The sealing resin layer 9 seals the solar cell element 8. More specifically, the sealing resin layer 9 buries the solar cell element 8 therein so as to expose the upper surface of the solar cell element 8.

Examples of a resin used to form the sealing resin layer 9 include an ethylene-vinyl acetate copolymer (EVA), polyvinyl butyral (PVB), and polyvinylidene fluoride.

The sealing resin layer 9 is in a generally rectangular shape larger than the solar cell element 8 when viewed in plan view, and the thickness thereof is larger than that of the solar cell element 8, and in a range of, e.g., 0.25 to 2 mm.

The upper cover glass layer 10 is provided on the uppermost surface (upper surface) side of the frameless solar cell module 7, and specifically laminated on the sealing resin layer 9 so as to cover the sealing resin layer 9. The upper cover glass layer 10 is in a generally rectangular shape of the same size as that of the sealing resin layer 9 when viewed in plan view. The peripheral end surface of the upper cover glass layer 10 is formed to be flush with the peripheral end surface of the sealing resin layer 9 in the thickness direction. The thickness of the upper cover glass layer 10 is in a range of, e.g., 3 to 12 mm.

The lower cover glass layer 11 is provided on the lowermost surface (lower surface) side of the frameless solar cell module 7, and specifically laminated under the sealing resin layer 9 such that the sealing resin layer 9 is sandwiched between the upper cover glass layer 10 and the lower cover glass layer 11 in the thickness direction. The lower cover glass layer 11 is in a generally rectangular shape of the same size as that of the sealing resin layer 9 when viewed in plan view, and the peripheral end surface thereof is formed to be flush with the peripheral end surface of the sealing resin layer 9 in the thickness direction. The thickness of the lower cover glass layer 11 is in a range of, e.g., 3 to 12 mm.

To the peripheral end portion 15 of the frameless solar cell module 7, the adhesive seal material 1 for the end portion of the frameless solar cell module is bonded.

Next, a method of bonding the adhesive seal material 1 for the end portion of the frameless solar cell module to the frameless solar cell module 7 is described with reference to FIGS. 1 and 2.

First in this method, as indicated by the imaginary line of FIG. 1, the exfoliate sheet 16 laminated on the surface of the adhesive seal material 1 for the end portion of the frameless solar cell module is stripped from the adhesive layer 3.

Separately, as shown in FIG. 2, the frameless solar cell module 7 described above is prepared.

Then, the surface of the adhesive seal material 1 for the end portion of the frameless solar cell module, i.e., the surface of the adhesive layer 3 is bonded to the peripheral surface of the peripheral end portion 15 of the frameless solar cell module 7.

More specifically, the adhesive layer 3 is bonded continuously to the peripheral side surface and upper surface of the upper cover glass layer 10, to the peripheral side surface of the sealing resin layer 9, and to the peripheral side surface and lower surface of the lower cover glass layer 11 at the peripheral end portion 15 of the frameless solar cell module 7 such that the peripheral end portion 15 of the frameless solar cell module 7 is sandwiched by the frameless solar cell module 7 formed in a U-shaped cross-sectional shape.

Thus, the foregoing adhesive seal material 1 for the end portion of the frameless solar cell module can be easily bonded to the frameless solar cell module 7.

Also, the foregoing adhesive seal material 1 for the end portion of the frameless solar cell module has excellent adhesion to the frameless solar cell module 7, and therefore strong adhesion to the frameless solar cell module 7 can be achieved.

Also, the foregoing adhesive seal material 1 for the end portion of the frameless solar cell module has an excellent water vapor barrier property. Therefore, by imparting the excellent water vapor barrier property to the peripheral end portion 15 of the frameless solar cell module 7, it is possible to prevent the entrance of moisture into the gap between the adhesive seal material 1 for the end portion of the frameless solar cell module and the peripheral end portion 15 of the frameless solar cell module 7, and prevent the short circuit of the solar cell element 8. As a result, it is possible to improve the water resistance and reliability of the frameless solar cell module 7.

Additionally, the foregoing adhesive seal material 1 for the end portion of the frameless solar cell module also has excellent light resistance, weathering resistance (such as moisture resistance), and heat resistance (such as moisture and heat resistance). Therefore, even when the frameless solar cell module 7 is used in a severe environment, it is possible to ensure water resistance and reliability over a long period of time.

Moreover, the adhesive seal material 1 for the end portion of the frameless solar cell module exhibits an excellent cushioning property to its surroundings. Therefore, during wrapping, transportation, or the like, the peripheral end portion 15 of the frameless solar cell module 7 can be effectively prevented from coming into contact with a wrapping member, a transportation member, or the like therearound, and being damaged thereby. This allows protection of the peripheral end portion 15 of the frameless solar cell module 7.

The frameless solar cell module 7 and a sealed structure of the peripheral end portion 15 of the frameless solar cell module 7 can ensure excellent endurance as well as excellent water resistance and reliability.

In the description given above, the adhesive seal material 1 for the end portion of the frameless solar cell module is bonded to each of the peripheral side surface, upper surface, and lower surface of the peripheral end portion 15 of the frameless solar cell module 7. However, it is also possible to bond the adhesive seal material 1 for the end portion of the frameless solar cell module only to the peripheral side surface of the peripheral end portion 15 of the frameless solar cell module 7, and expose the upper surface and lower surface thereof, though not shown.

Preferably, in terms of the water vapor barrier property, the adhesive seal material 1 for the end portion of the frameless solar cell module is bonded to each of the peripheral side surface, upper surface, and lower surface of the peripheral end portion 15 of the frameless solar cell module 7.

The foregoing adhesive seal material 1 for the end portion of the frameless solar cell module can also include a protective layer 14 formed on the back surface of the barrier layer 5, as shown in FIG. 3.

The protective layer 14 is provided so as to protect the adhesive seal material 1 for the end portion of the frameless solar cell module from solar light (including an ultraviolet ray) and the surroundings thereof, and preferably laminated on the entire back surface of the barrier layer 5. The protective layer 14 includes, e.g., a light shielding layer formed on the back surface of the barrier layer 5, and a clear layer formed on the back surface of the light shielding layer.

The light shielding layer is formed of a pigment composition containing, e.g., a black pigment (such as, e.g., carbon black) as a main component thereof. The thickness of the light shielding layer is in a range of, e.g., 5 to 20 µm, or preferably 5 to 10 µm.

The clear layer is formed of a resin composition containing, e.g., a transparent resin such as an acrylic resin as a main component thereof. The thickness of the clear layer is in a range of, e.g., 5 to 20 µm, or preferably 5 to 10 µm.

The thickness of the protective layer 14 is in a range of, e.g., 10 to 40 µm, or preferably 10 to 20 µm.

By the protective layer 14, the light resistance of the adhesive seal material 1 for the end portion of the frameless solar cell module, the weathering resistance thereof, and hence the endurance thereof can further be improved.

### EXAMPLES

Hereinbelow, the present invention is described more specifically by showing the examples and the comparative examples. However, the present invention is by no means limited thereto.

### (Preparation of Butyl-Based Adhesive Composition and Formation of Adhesive Layer)

### PREPARATION EXAMPLE 1

Using a 75 L pressure kneader, 100 parts by weight of a reclaimed butyl rubber (having a Mooney viscosity of (ML1+4, 100 °C), 34 parts by weight (corresponding to 2/3 of a total amount) of a tackifier (produced under the tradename of "Escorez 1202U" by TONEX Co., Ltd.), and 150 parts by weight of heavy calcium carbonate were kneaded at a temperature of 120 °C and under a pressure in the range of 0.1 to 0.3 MPa for 10 minutes to prepare a master batch.

Then, using an open kneader, 16 parts by weight of Escorez 1202U (the remainder corresponding to 2/3 of the total amount), 10 parts by weight of polybutene (liquid polybutene produced under the tradename of "HV-300" by Nippon Petrochemicals Co., Ltd.), and 30 parts by weight of Diana Process Oil (produced under the tradename of "Diana Process Oil PW-90" by Shin Nihon Yushi Kogyo Co., Ltd.) were kneaded into the foregoing master batch at a temperature of 120 °C to prepare a butyl-based adhesive composition.

Then, the butyl-based adhesive composition was calendared with a calendar roll to form an adhesive layer having a thickness of 400 µm.

Thereafter, an exfoliate sheet was laminated on each of the top surface and back surface of the obtained adhesive layer.

The formulation of the individual components of the butyl-based adhesive composition is shown in Table 1.

### PREPARATION EXAMPLE 2

According to the formulation of Table 1, by the same process as in PREPARATION EXAPLE 1, a butyl-based adhesive composition was prepared. Subsequently, from the prepared butyl-based adhesive composition, an adhesive layer having a thickness of 500 µm and an adhesive layer having a thickness of 250 µm were each formed.

The formulation of the butyl-based adhesive composition is shown in Table 1.

### PREPARATION EXAMPLE 3

According to the formulation of Table 1, by the same process as in PREPARATION EXAPLE 1, a butyl-based adhesive composition was prepared. Subsequently, from the prepared butyl-based adhesive composition, an adhesive layer having a thickness of 800 µm was formed.

The formulation of the butyl-based adhesive composition is shown in Table 1. Table 1

**Table 1**

| Formulation of Butyl-Based Adhesive Composition | | | Preparation Example 1 | Preparation Example 2 | Preparation Example 3 |
|---|---|---|---|---|---|
| Butyl Rubber | Reclaimed Butyl Rubber | Master Batch Components | 100 | 70 | 100 |
| | Synthetic Rubber JSR Butyl 268 | | - | 30 | - |
| Filler | Heavy Calcium Carbonate | | 150 | 100 | 200 |
| Tackifier | Petroleum-Type Resin Escorez 1202U | | 34 | 26.7 | 34 |
| | | Final Batch Components | 16 | 13.3 | 16 |
| Softner | Liquid Polybutene HV-300 | | 10 | 60 | 110 |
| | Cumic Process Oil 8465 | | - | 5 | - |
| | Diana Process Oil PW-90 | | 30 | - | - |
| Vulcanizer | Dinitroso-Type Vulnoc DNB | | - | - | 2 |

### (Production of Adhesive Seal Material for End Portion of Frameless Solar Cell Module)

### EXAMPLE 1

A CLAF-reinforced aluminum foil (having a thickness of 130 µm) in which an aluminum foil having a thickness of 7 µm was bonded with an ionomer to the back surface of a CLAF fabric (having the model number "MS24", a basis weight of 29 g/m², a maximum interfiber spacing of 2.4 mm, and a thickness of 100 µm, and produced by NISSEKI PLASTO CO., LTD.) was prepared.

Next, the exfoliate sheet on the back surface of the adhesive layer obtained according to PREPARATION EXAMPLE 1 was stripped from the adhesive layer. Then, the back surface of the adhesive layer was bonded under a pressure of 0.4 MPa to the surface (CLAF-side surface) of the CLAF-reinforced aluminum foil.

In this manner, an adhesive seal material for an end portion of a frameless solar cell module having a thickness of 530 µm was obtained (see FIG. 1).

### EXAMPLE 2

An adhesive seal material for an end portion of a frameless solar cell module having a thickness of 540 µm was obtained in the same manner as in EXAMPLE 1 except that the thickness of the CLAF-reinforced aluminum foil was changed to 140 µm (see FIG. 1).

That is, in the CLAF-reinforced aluminum foil, the thickness of the aluminum foil was 25 µm, and the thickness of the CLAF fabric was 100 µm.

### EXAMPLE 3

A CLAF-reinforced aluminum foil was prepared in the same manner as in EXAMPLE 1, and a pigment composition (black lacquer paint) was applied to the back surface (aluminum-foil-side surface) thereof and dried to subsequently form a light shielding layer having a thickness of 5 µm.

Then, to the back surface (surface opposite to the aluminum-foil-side surface) of the light shielding layer, a resin composition (acrylic resin) was applied and dried to subsequently form a clear layer having a thickness of 5 µm.

Next, the exfoliate sheet on the back surface of the adhesive layer obtained according to PREPARATION EXAMPLE 1 was stripped from the adhesive layer. Then, the back surface of the adhesive layer was bonded under pressure to the surface (CLAF-side surface) of the CLAF-reinforced aluminum foil.

In this manner, an adhesive seal material for an end portion of a frameless solar cell module having a thickness of 540 µm was obtained (see FIG. 3).

### EXAMPLE 4

A CLAF-reinforced aluminum foil was prepared in the same manner as in EXAMPLE 2, and a pigment composition (black lacquer paint) was applied to the back surface (aluminum-foil-side surface) thereof and dried to subsequently form a light shielding layer having a thickness of 5 µm.

Then, to the back surface (surface opposite to the aluminum-foil-side surface) of the light shielding layer, a resin composition (acrylic resin) was applied and dried to subsequently form a clear layer having a thickness of 5 µm.

Next, the exfoliate sheet on the back surface of the adhesive layer obtained according to PREPARATION EXAMPLE 1 was stripped from the adhesive layer. Then, the back surface of the adhesive layer was bonded under pressure to the surface (CLAF-side surface) of the CLAF-reinforeed aluminum foil.

In this manner, an adhesive seal material for an end portion of a frameless solar cell module having a thickness of 550 µm was obtained (see FIG. 3).

### COMPARATIVE EXAMPLE 1

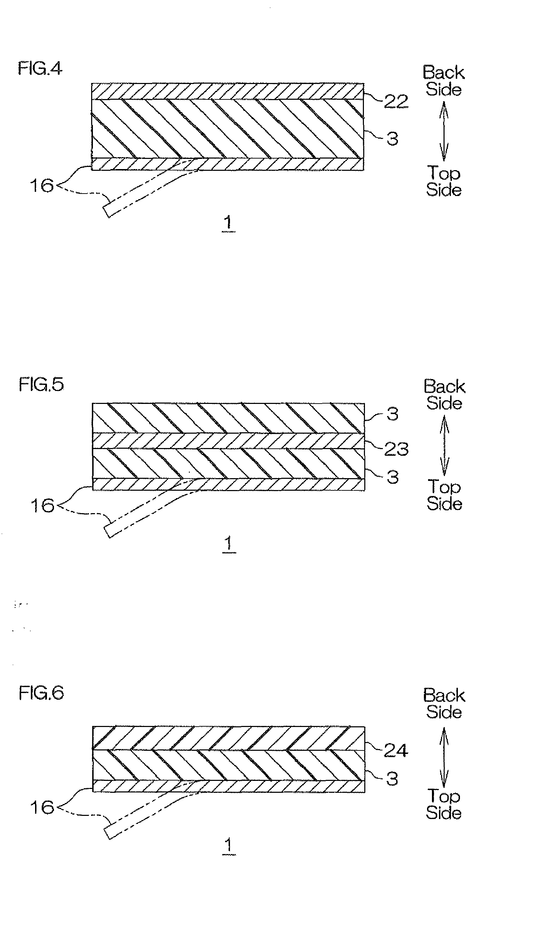

As shown in FIG. 4, a base material (22) was prepared by impregnating a polyester non-woven fabric (produced under the tradename of "Eltas E01050" by ASAHI KASEI FIBERS CORPORATION) having a thickness of 300 µm with an acrylic resin containing aluminum powder.

Next, the exfoliate sheet on the back surface of an adhesive layer (3) having a thickness of 500 µm obtained according to PREPARATION EXAMPLE 2 was stripped from the adhesive layer (3). Then, the back surface of the adhesive layer was bonded under a pressure of 0.4 MPa to a surface of the base material (22).

In this manner, an adhesive seal material (1) for an end portion of a frameless solar cell module having a thickness of 700 µm was obtained.

### COMPARATIVE EXAMPLE 2

A cellulose-type base material (produced under the tradename of "80-Thread Muslin" by OTOYO SHOKUFU CORPORATION) (23) having a thickness of 200 µm was prepared.

Next, as shown in FIG. 5, the exfoliate sheet on the top surface of the adhesive layer (3) having a thickness of 250 µm obtained according to PREPARATION EXAMPLE 2 was stripped from the adhesive layer (3). Then, the adhesive layer was bonded under a pressure of 0.4 MPa to each of the both surfaces of the base material (23).

In this manner, the adhesive seal material (1) for the end portion of the frameless solar cell module having a thickness of 500 µm was obtained.

### COMPARATIVE EXAMPLE 3

An EPDM-type non-crosslinked rolled sheet (24) having a thickness of 500 µm was prepared.

Next, as shown in FIG. 6, the exfoliate sheet on the back surface of the adhesive layer (3) obtained according to PREPARATION EXAMPLE 3 was stripped from the adhesive layer (3). Then, the back surface of the adhesive layer was bonded under a pressure of 0.4 MPa to a surface of the base material (24).

In this manner, the adhesive seal material (1) for the end portion of the frameless solar cell module having a thickness of 1300 µm was obtained.

### (Evaluation)

### (1) Peel Adhesion Force (Adhesion Force to Glass)

Each of the adhesive seal material s for the end portion of the frameless solar cell module of EXAMPLES and COMPARATIVE EXAMPLES was cut into the size of a width of 25 mm and a length of 100 mm, and the exfoliate sheet was stripped therefrom. After an adhesive was placed on a surface of a glass substrate, by reciprocating a 2 kg roller once, the adhesive seal material for the end portion of the frameless solar cell module was bonded to the surface of the glass substrate.

Thereafter, at the temperatures shown below, the adhesive seal material s for the end portion of the frameless solar cell module were allowed to stand still for one hour at the following temperatures so that the bonding (adhesion) states thereof were stabilized. Then, by holding the end portions of the adhesive seal material s for the end portion of the frameless solar cell module, and peeling the adhesive seal material s for the end portion of the frameless solar cell module each at an angle of 180 degrees with respect thereto and at a speed of 300 mm/minute, the peel adhesion forces (adhesion forces to glass) thereof were measured.

| | |
|---|---|
| Temperatures: | -40 °C |
| | 0 °C |
| | 23 °C |
| | 60 °C |
| | 90 °C |

### (2) Moisture Permeability

For each of the adhesive seal material s for the end portion of the frameless solar cell module of EXAMPLES and COMPARATIVE EXAMPLES, a moisture permeability at a temperature of 40 °C and a relative humidity of 90% according to a moisture permeability test method of JIS Z0208 was measured.

Note that each of the adhesive seal material s for the end portion of the frameless solar cell module was placed in a test cup such that the base material thereof is disposed at an overlying position, and an adhesive was positioned thereunder.

The result of the measurement is shown in Table 2. Table 2

**Table 2**

| Examples/ Comparative Examples | | | Example 1 | Example 2 | Example 3 | Example 4 | Comparative Example 1 | Comparative Example 2 | Comparative Example 3 |
|---|---|---|---|---|---|---|---|---|---|
| Base Material | | | CLAF-Reinforced Aluminum Foil (CLAF Fabric + Aluminum Foil) | | | | Polyester Non-Woven Fabric Impregnated with Acrylic Resin | Cellulose-Type Base Material | EPDM-Type Non-Crosslinked Sheet |
| Protective Layer | | | - | - | Black Pigment Layer & Transparent Resin Layer | | - | - | - |
| Adhesive Layer | | | Preparation Example 1 | | | | Preparation Example 2 | Preparation Example 2 (Double-Layered) | Preparation Example 3 |
| Adhesion Force to Glass (N/25 mm) | Temperature | -40 | 89 | 100 | 89 | 100 | 105 | 72 | 214 |
| | | 0 | 38 | 45 | 38 | 45 | 51 | 29 | 89 |
| | | 23 | 21 | 35 | 21 | 35 | 69 | 25 | 25 |
| | | 60 | 4 | 6 | 4 | 6 | 7 | 7 | 6 |
| | | 90 | 2 | 3 | 2 | 3 | 3 | 4 | 4 |
| Moisture Permeability (g/m²/24 Hours) | | 23 °C 50% RH | 0.16 | 0.12 | 0.16 | 0.12 | 0.85 | 0.81 | 0.99 |

## Claims

1. An adhesive seal material for an end portion a frameless solar cell module which is bonded to an end portion of a frameless solar cell module, comprising:
a base material; and
an adhesive layer formed on a surface of the base material, wherein
the base material includes:
a reinforcement layer having a top surface on which the adhesive layer is laminated ; and
a barrier layer formed on a back surface of the reinforcement layer.

2. The adhesive seal material for the end portion of the frameless solar cell module according to Claim 1, wherein the barrier layer is a metal foil.

3. The adhesive seal material for the end portion of the frameless solar cell module according to Claim 2, wherein the metal foil is an aluminum foil and/or a copper foil.

4. The adhesive seal material for the end portion of the frameless solar cell module according to Claim 1, wherein the reinforcement layer is a split-fiber non-woven fabric.

5. The adhesive seal material for the end portion of the frameless solar cell module according to Claim 1, wherein the adhesive layer is made of a butyl-based adhesive composition.

6. The adhesive seal material for the end portion of the frameless solar cell module according to Claim 1, wherein a moisture permeability at a temperature of 40 °C and a relative humidity of 90% in accordance with a moisture permeability test method of JIS Z0208 is not more than 0.2 g/m²/24 hours.

7. The adhesive seal material for the end portion of the frameless solar cell module according to Claim 1, further comprising:
a protective layer formed on the back surface of the barrier layer to protect the adhesive seal material for the end portion of the frameless solar cell module.

8. A frameless solar cell module, wherein, to an end portion thereof, bonded is an adhesive layer of an adhesive seal material for the end portion of the frameless solar cell module, comprising: a base material; and the adhesive layer formed on a surface of the base material, wherein the base material includes: a reinforcement layer having a top surface on which the adhesive layer is laminated ; and a barrier layer formed on a back surface of the reinforcement layer.

9. The frameless solar cell module according to Claim 8, comprising:
a solar cell element;
a sealing resin layer sealing the solar cell element; and
a cover glass layer covering the sealing resin layer, wherein
the adhesive seal material for the end portion of the frameless solar cell module is bonded continuously to at least a side surface of the sealing resin and a side surface of the cover glass layer.

10. A sealed structure of an end portion of a frameless solar cell module, wherein, to the end portion of the frameless solar cell module, bonded is an adhesive seal material for the end portion of the frameless solar cell module, comprising: a base material; and an adhesive layer formed on a surface of the base material, wherein the base material includes: a reinforcement layer having a top surface on which the adhesive layer is laminated; and a barrier layer formed on a back surface of the reinforcement layer.
